# EUROPEAN PATENT APPLICATION

(11) **EP 4 266 380 A1**
(43) Date of publication of application: **25.10.2023**
(21) Application number: 23167324.5
(22) Date of filing: 11.04.2023
(51) Int. Cl.: H01L 31/05, H01L 31/18

(54) **SOLAR CELL MODULE**

(30) Priority: 15.04.2022 JP 2022067645
(71) Applicant: Panasonic Holdings Corporation, Osaka 571-8501 (JP)
(72) Inventor: IRIKAWA, Junpei, Osaka-shi, Osaka, 540-6207 (JP); HASHIMOTO, Haruhisa, Osaka-shi, Osaka, 540-6207 (JP)
(74) Representative: Müller-Boré & Partner Patentanwälte PartG mbB

(57) **Abstract**

A solar cell module (10) includes a solar cell string in which a plurality of solar cells (3) are electrically connected in series by a wiring member (4). The solar cell (3) has a cross section (40) positioned between a light receiving surface and a back surface. The cross section includes a first cross section part (40a) having a root mean square roughness of greater than or equal to a first value, and a second cross section part (40b) having a root means square roughness of less than the first value. The wiring member (4) is placed to be closer to the second cross section part (40b) than to the first cross section part (40a), at a position intersecting the cross section (40) in plan view viewed from a light receiving surface side in a thickness direction.

## Description

### TECHNICAL FIELD

The present disclosure relates to a solar cell module.

### BACKGROUND

In recent years, a wafer size is rapidly becoming larger in order to reduce a cost for manufacturing a solar cell module. However, with a larger wafer size, a short-circuit current (a current which flows when an output terminal of the solar cell module is shortcircuited) becomes larger, resulting in a larger resistance loss (Joule heat). Thus, in order to reduce the resistance loss, in some cases, the solar cell is divided, to reduce the short-circuit current.

In relation to this, as a method of fracturing the solar cell, there is known a method disclosed in JP 2006-286673 A. In this method of fracturing the solar cell, first, laser light is scanned (moved) along a location of fracture, to form a groove to a depth of about a half of the thickness over the entire region of the fracture location of the solar cell before the fracturing. Then, a mechanical force is applied to the solar cell separated to about a half of the thickness, to fracture the remaining thickness portion with the groove as a starting point, to thereby fracture the solar cell. In this fracturing method, because the groove is formed by the laser light only to a depth of about a half of the thickness, the laser light does not reach a pn junction of the solar cell, which significantly affects a cell conversion efficiency, and thus, reduction of the cell conversion efficiency can be suppressed.

When the solar cell is divided using the fracturing method described in JP 2006-286673 A, because solar cells can be manufactured by dividing a large-size wafer, the resistance loss of the solar cell module and the manufacturing cost can be reduced. However, a surface roughness of the portion where the fracturing is performed using the laser light becomes rougher than a portion which is fractured by applying the mechanical force. Thus, large recesses and protrusions are present in the portion where the fracturing is performed with the laser light, and the portion where the fracturing is performed with the laser light tends to easily crack when locally experiencing an excessive force. Therefore, in the case where the wafer thickness is thin or the like and the solar cell module experiences an excessive external force due to snowfall, typhoon, or the like, the laser-light-fractured portion experiences an excessive force (stress) from a wiring member, resulting in a possibility of cracks in the solar cell with the fractured portion as a starting point. An advantage of the present disclosure lies in provision of a solar cell module in which the resistance loss can be reduced and which is superior in load resistance.

### SUMMARY

According to one aspect of the present disclosure, there is provided a solar cell module including: a solar cell string in which a plurality of solar cells are electrically connected in series by a wiring member; a light-receiving-surface-side protection member placed on a light receiving surface side in a thickness direction of the solar cell string; a back-surface-side protection member placed on a back surface side in the thickness direction of the solar cell string; and a sealing member provided between the light-receiving-surface-side protection member and the back-surface-side protection member, that covers the solar cell string, wherein the solar cell has a light receiving surface, a back surface, and a cross section positioned between the light receiving surface and the back surface, the cross section includes a first cross section part having a root mean square roughness of greater than or equal to a first value, and a second cross section part having a root mean square roughness of less than the first value, and the wiring member is placed to be closer to the second cross section part than to the first cross section part, at a position intersecting the cross section in plan view viewed from the light receiving surface side in the thickness direction. As the first value, for example, a value of 10 µm may be employed.

According to another aspect of the present disclosure, there is provided a solar cell module including: a solar cell string in which a plurality of solar cells are electrically connected in series by a wiring member; a light-receiving-surface-side protection member placed on a light receiving surface side in a thickness direction of the solar cell string; a back-surface-side protection member placed on a back surface side in the thickness direction of the solar cell string; and a sealing member provided between the light-receiving-surface-side protection member and the back-surface-side protection member, that covers the solar cell string, wherein the solar cell has a light receiving surface, a back surface, and a cross section positioned between the light receiving surface and the back surface, the cross section includes a first cross section part having a laser irradiation trace in at least a part thereof, and a second cross section part in which there is no laser irradiation trace, and the wiring member is placed to be closer to the second cross section part than to the first cross section part, at a position intersecting the cross section in plan view viewed from the light receiving surface side in the thickness direction.

The first cross section part having the laser irradiation trace in at least a part thereof may be defined as a cross-section part which satisfies both conditions that a trace which is solidified after a material has melted remains in at least a part thereof, and that there is no cross-section part formed along a cleavage. In this case, the second cross section part may be defined as a cross-section part on a same plane as the first cross section and in which there is no trace which is solidified after the material has melted or a cross section formed along the cleavage.

According to the solar cell module of an aspect of the present disclosure, the resistance loss can be reduced and a superior load resistance can be realized.

### BRIEF DESCRIPTION OF DRAWINGS

The figures depict one or more implementations in accordance with the present teachings, by way of example only, not by way of limitations. In the figures, like reference numerals refer to the same or similar elements. Embodiments of the present disclosure will be described based on the following figures, wherein:
FIG. 1 is a schematic plan view of a solar cell module according to a first embodiment of the present disclosure, viewed from a front surface side in a thickness direction;
FIG. 2 is a diagram showing a part of a cross section along a line A-A of FIG. 1;
FIG. 3 is a schematic diagram for explaining a method of manufacturing a solar cell according to the first embodiment of the present disclosure;
FIG. 4 is a schematic diagram for explaining fracturing of a solar cell according to the first embodiment of the present disclosure;
FIG. 5 is a plan view of a cross section (fractured surface) of the solar cell shown in FIG. 4(b), viewed from the side;
FIG. 6 is a diagram showing a part of a cross section of a solar cell module according to the first embodiment of the present disclosure, cut in a plane perpendicular to a direction of extension of a wiring member;
FIG. 7 is a schematic diagram for explaining a fracturing method of a solar cell in the related art;
FIG. 8 is a schematic diagram for explaining a structure of a fractured surface caused by a fracturing method of a solar cell in the related art;
FIG. 9 is a schematic cross-sectional diagram perpendicular to a direction of extension of a wiring member in a solar cell module in the related art, for explaining a reason why cracks tend to be easily generated in a solar cell of the solar cell module in the related art;
FIG. 10 is a schematic cross-sectional diagram perpendicular to a direction of extension of a wiring member in a solar cell module, for explaining a structure which can be employed in a solar cell module according to the first embodiment of the present disclosure;
FIG. 11 is a schematic plan view of a part of a solar cell string, viewed from a back surface side in a thickness direction, for explaining a structure which can be employed in the first embodiment of the present disclosure;
FIG. 12 is a schematic perspective diagram of a solar cell for explaining an example of a solar cell which can be equipped on a solar cell module according to the first embodiment of the present disclosure, viewed from a back surface side;
FIG. 13 is a schematic diagram corresponding to FIG. 3, for explaining a method of manufacturing a solar cell according to a second embodiment of the present disclosure;
FIG. 14A is a schematic perspective diagram of a solar cell viewed from a back surface side, for explaining one possible example structure of a solar cell manufactured by the method shown in FIG. 13;
FIG. 14B is a schematic perspective diagram of a solar cell viewed from a back surface side, for explaining another possible example structure of a solar cell manufactured by the method shown in FIG. 13;
FIG. 14C is a schematic perspective diagram of a solar cell viewed from a back surface side, for explaining yet another possible example structure of a solar cell manufactured by the method shown in FIG. 13; and
FIG. 15 is a schematic side view for explaining a structure of a cross section of a solar cell according to a third embodiment of the present disclosure.

### DESCRIPTION OF EMBODIMENTS

Embodiments of the present disclosure will now be described in detail with reference to the attached drawings. In the following, when a plurality of embodiments and alternative configurations are included, suitable combination of characteristic portions thereof to construct a new embodiment is conceived of from the beginning. In the following embodiments, similar structures in the drawings are assigned similar reference numerals, and repeated descriptions thereof will not be given. Furthermore, the plurality of drawings include schematic diagrams, and a size ratio of vertical, horizontal, and height sizes or the like in the members are not necessarily the same over different drawings. Furthermore, of constituting elements described below, the constituting elements which are not described in an independent claim describing the uppermost concept are optional constituting elements, and are not necessary constituting elements. Moreover, the present disclosure is not limited to the embodiments and alternative configurations thereof described below, and various improvements and modifications are possible within the items described in the claims and equivalences thereof.

In the following description, in a solar cell module 10, a side on which the solar light is primarily incident (greater than 50% and less than or equal to 100%) will be described as a light receiving surface side (front surface side), and a side opposite to the front surface side will be described as a back surface side. In the following description and in the drawings, an X direction is a direction of extension of a solar cell string 50 to be described below, and a Y direction is a direction orthogonal to the X direction, and is a direction of arrangement of a plurality of solar cell strings 50 arranged in a plurality of lines. A Z direction is a direction orthogonal to the X direction and the Y direction, and is a thickness direction of the solar cell module 10. In the following description, a cross section is a cell fractured surface, and a cross section part is a cell fractured surface part, and is a part of the cell fractured surface.

### (First Embodiment)

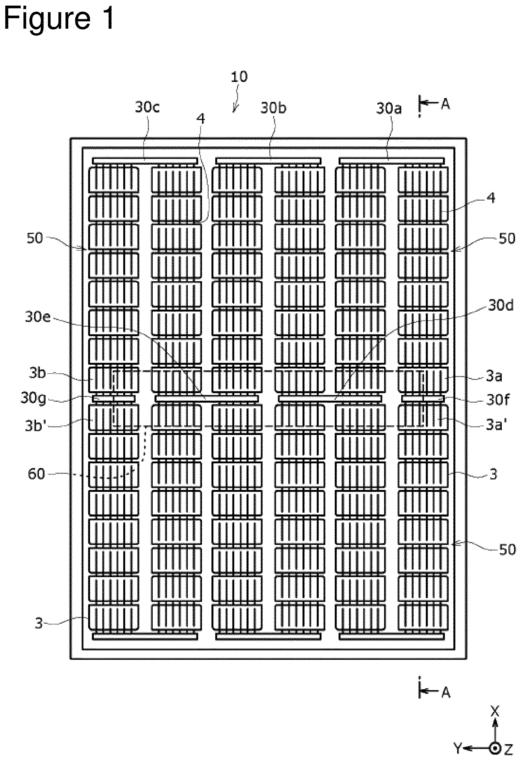

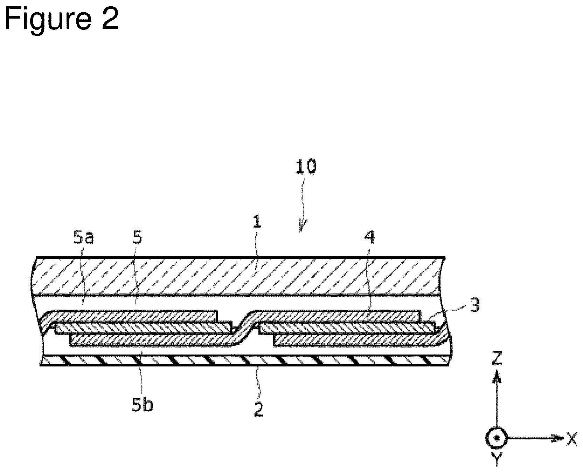

FIG. 1 is a schematic plan view of a solar cell module 10 according to a first embodiment of the present disclosure, viewed from the front surface side in the Z direction. FIG. 2 is a diagram showing a part of a cross section along a line A-A in FIG. 1. As shown in FIG. 1, the solar cell module 10 has a flat plate shaped structure having an approximately rectangular shape in the plan view, and has a terminal box 60 at the back surface side in the Z direction at a center portion in a longitudinal direction (X direction) of the rectangular shape. As shown in FIG. 2, the solar cell module 10 includes a front-surface-side glass member 1 (hereinafter also referred to as a "front surface glass") which is an example of a light-receiving-surface-side protection member, a resin sheet 2 which is an example of a back-surface-side protection member, a plurality of solar cells 3, a wiring member 4, and a sealing member 5.

The front surface glass 1 is provided on the light receiving surface side on which the light is primarily incident, and protects the front surface side of the solar cell module 10. The front surface glass 1 is formed from reinforced glass having a light transmitting property, and has a thickness of about 0.5-4.0 mm, desirably about 1.6-3.2 mm. The light-receiving-surface-side protection member is not limited to the reinforced glass, and alternatively, other light-transmissive members such as light-transmissive plastic may be used.

The resin sheet 2 is provided on the side opposite to the light receiving surface side, and protects the back surface side of the solar cell module 10. The resin sheet 2 is formed from a resin material such as, for example, polyvinyl fluoride (PVF) which is a thermoplastic fluoropolymer material, polyethylene terephthalate (PET), or the like. The resin sheet 2 is desirably formed from a material which is stable within a temperature range of -40°C-+85°C, and may be formed from a transparent material so that the solar light can efficiently enter the solar cell module 10 from both sides.

Alternatively, the resin sheet 2 may be formed from a white back sheet. In this case, the light incident on the back sheet can be reflected by the resin sheet 2, so that an amount of light entering the solar cell 3 can be increased and an amount of power generation by the solar cell module can be increased. Alternatively, a back-surface-side glass member (back surface glass) may be employed as the back-surface-side protection member. In this case, the back surface glass is formed from, for example, reinforced glass with a thickness of about 0.5-4.0 mm or less, desirably about 1.6-3.2 mm, and is formed to have weather resistance. The back surface glass may be light transmissive or non-light transmissive.

The plurality of the solar cells 3 are placed between the front surface glass 1 and the resin sheet 2. The solar cell 3 is formed from, for example, a crystalline semiconductor formed from monocrystalline silicon, polycrystalline silicon, or the like. The solar cell 3 has, for example, an n-type region and a p-type region, and a junction for generating an electric field for separating the carriers is provided at the interface portion between the n-type region and the p-type region. An upper surface of the solar cell 3 has, for example, an approximately square shape, but the shape of the upper surface of the solar cell 3 is not limited to such a shape.

The wiring member 4 electrically connects, in two solar cells 3 that are adjacent in the X direction, an electrode on a light receiving surface side of one solar cell 3 with an electrode on a back surface side of the other solar cell 3. The wiring member 4 is attached to the electrodes with an adhesive or the like. The wiring member 4 is desirably formed from, for example, a thin plate-shape copper foil and solder coated on the surface of the copper foil or a solder coated copper wire having approximately circular cross section, but may alternatively be formed with any conductor other than this structure.

The sealing member 5 is filled between the front surface glass 1 and the resin sheet 2, and seals the plurality of solar cells 3 between the front surface glass 1 and the resin sheet 2. A thickness of the sealing member 5 is about 400-700 µm. The sealing member 5 includes a front encapsulant 5a and a back encapsulant 5b. The front encapsulant 5a is placed between the front surface glass 1 and the solar cell 3, and the back encapsulant 5b is placed between the solar cell 3 and the resin sheet 2. For example, the front encapsulant 5a is formed from a transparent encapsulant, and the back encapsulant 5b is formed from a transparent or white encapsulant. When the sealing member 5 includes the front encapsulant 5a having a superior light transmittance and the back encapsulant 5b having a superior reflective property of light, usage efficiency of light can be improved. Alternatively, the back-surface-side protection member may be the transparent back sheet or the back surface glass, in which case the back encapsulant 5b is formed from the transparent encapsulant.

The front encapsulant 5a and the back encapsulant 5b are bonded and layered with each other in a laminate treating performed at a temperature of about 100°C-160°C. For example, the front encapsulant 5a is layered over the front surface glass 1, and then a plurality of solar cell strings 50, in each of which a plurality of solar cells 3 are electrically connected in series by the wiring member 4, and extending in the X direction, are placed with a spacing in the Y direction. Then, the solar cell strings 50 and an outlet wiring are connected, the back encapsulant 5b and the resin sheet 2 are layered thereover, and the resulting structure is pressed while being heated in this state to integrate the respective members. Alternatively, the back encapsulant 5b, the plurality of solar cell strings 50 electrically connected to each other, the front encapsulant 5a, and the front surface glass 1, may be layered over the resin sheet 2, and the resulting structure may be pressed while being heated.

The back encapsulant 5b is desirably formed from a material which satisfies at least one of a condition that the back encapsulant 5b has a higher hardness than the front encapsulant 5a, or has a lower fluidity than the front encapsulant 5a at a temperature at which the laminate treatment is performed. The front encapsulant 5a is desirably formed from, for example, an ethylene-vinyl acetate copolymer or polyolefin, but is not limited to these materials. The back encapsulant 5b is desirably formed from, for example, the ethylene-vinyl acetate copolymer or the polyolefin, but is not limited to these materials. A colored back encapsulant is not necessarily formed from a white encapsulant. Alternatively, when the back-surface-side protection member is the transparent back sheet or the back surface glass as described above, the back encapsulant is formed from a transparent encapsulant.

With reference again to FIG. 1, two or more solar cells 3 placed on the same straight line along the X direction are connected in series by the wiring member 4. The two or more solar cells 3 placed on the same straight line and a plurality of wiring members 4 connecting the two or more solar cells 3 in series form the solar cell string 50. In the example configuration shown in FIG. 1, with the center portion in the X direction as a boundary, a plurality of solar cells 3 placed on one side in the X direction and a plurality of solar cells 3 placed on the other side in the X direction are connected in parallel to each other. The plurality of solar cells 3 placed on the one side or the other side in the X direction are connected in series. As a result, in relation to the plurality of solar cells 3 placed on the one side in the X direction, a solar cell 3a placed at the rightmost position on the page and the closest to the center side is placed at the lowest potential side, and a solar cell 3b placed at the leftmost position on the page and the closest to the center side is placed at the highest potential side. In relation to the plurality of solar cells 3 placed on the other side in the X direction, a solar cell 3a' placed at the rightmost position on the page and the closest to the center side is placed at the lowest potential side, and a solar cell 3b' placed at the leftmost position on the page and the closest to the center side is placed at the highest potential side.

Next, the electrical connection of the solar cell module 10 will be described in further detail. An electrical connection structure of the plurality of solar cells 3 placed on the other side in the X direction (hereinafter also referred to as "other-side connection structure") is identical to an electrical connection structure of the plurality of solar cells 3 placed on the one side in the X direction (hereinafter also simply referred to as "the one-side connection structure"), and description thereof will be omitted. The solar cell module 10 has three one-side bridge wirings 30a, 30b, and 30c, and two common bridge wirings 30d and 30e. The one-side bridge wiring 30a electrically connects a high potential side of a solar cell string 50 that is positioned at the rightmost position in the one-side connection structure and is at the lowest potential, and a low potential side of a solar cell string 50 that is positioned at a second position from the right in the one-side connection structure and has the second lowest potential. The common bridge wiring 30d is a bridge wiring positioned at the center portion in the X direction and shared by the one-side connection structure and the other-side connection structure. The common bridge wiring 30d electrically connects a high potential side of the solar cell string 50 having the second lowest potential in the one-side connection structure and a low potential side of a solar cell string 50 that is positioned at a third position from the right in the one-side connection structure and has a third lowest potential.

The one-side bridge wiring 30b electrically connects a high potential side of the solar cell string 50 having the third lowest potential in the one-side connection structure and a low potential side of a solar cell string 50 positioned at a fourth position from the right in the one-side connection structure and having the fourth lowest potential. The common bridge wiring 30e is a bridge wiring positioned at the center portion in the X direction and shared by the one-side connection structure and the other-side connection structure. The common bridge wiring 30e electrically connects a high potential side of the solar cell string 50 having the fourth lowest potential in the one-side connection structure and a low potential side of a solar cell string 50 positioned at a fifth position from the right in the one-side connection structure and having the fifth lowest potential. The one-side bridge wiring 30c electrically connects a high potential side of the solar cell string 50 having the fifth lowest potential in the one-side connection structure and a low potential side of a solar cell string 50 positioned at a sixth position from the right in the one-side connection structure and having the highest potential.

The solar cell module 10 further has two common wirings 30f and 30g. The common wiring 30f electrically connects the solar cell 3a having the lowest potential in the one-side connection structure and the solar cell 3a' having the lowest potential in the other-side connection structure. As a result, the solar cell 3a and the solar cell 3a' are set at an equal potential. The common wiring 30g electrically connects the solar cell 3b having the highest potential in the one-side connection structure and the solar cell 3b' having the highest potential in the other-side connection structure. As a result, the solar cell 3b and the solar cell 3b' are set at an equal potential.

The terminal box 60 is attached to a back surface of the resin sheet 2 (refer to FIG. 2). A plurality of through holes are formed on the resin sheet 2. Each of the two common bridge wirings 30d and 30e and the common wirings 30f and 30g pass through a corresponding through hole, and are electrically connected to a predetermined terminal of the terminal box 60. The terminal box 60 may be integrally formed, and may have a split structure and include a plurality of different portions. The common wiring 30f is electrically connected to a low-potential-side electric power supply wiring (not shown) in the terminal box 60, and the common wiring 30g is electrically connected to a high-potential-side electric power supply wiring (not shown) in the terminal box 60. The terminal box 60 has a bypass diode connected between the common wiring 30f and the common bridge wiring 30d, a bypass diode connected between the common bridge wiring 30d and the common bridge wiring 30e, and a bypass diode connected between the common bridge wiring 30e and the common wiring 30g.

When a light blocking substance such as a fallen leaf covers a particular solar cell 3, the amount of power generation by the solar cell 3 may be reduced and heat may be generated. With the bypass diode provided, two solar cell strings 50 connected in series, including the solar cell 3 having the reduced amount of power generation, are shortcircuited by the bypass diode. As a result, approximately no current flows through the two solar cell strings 50, and damage to the solar cell 3 due to the heat generation can be suppressed. The electric power from the solar cell module 10 is taken out to the outside through the high-potential-side electric power supply wiring and the low-potential-side electric power supply wiring. In the example configuration shown in FIG. 1, a case is shown in which each connection structure has six solar cell strings 50, but alternatively, the number of the plurality of solar cell strings 50 in each connection structure may be a value other than six. Alternatively, the solar cell module may have a structure in which the plurality of connection structure connected in parallel with each other is not formed, and all solar cells of the solar cell module are connected in series.

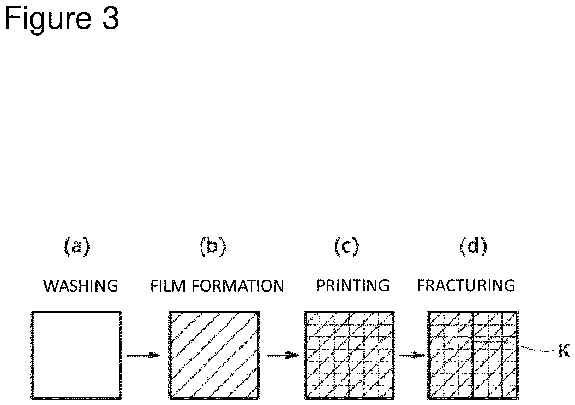

Next, a structure of the solar cell 3, a structure of the solar cell module 10, and methods of manufacturing these structures will be described. In the following description, a case will be exemplified in which the solar cell 3 is a heterojunction (HJT) solar cell. Alternatively, the solar cell 3 may be a PERC (Passivated Emitter and Rear Cell) solar cell, or a TOPCON (Tunnel Oxide Passivated Contact) solar cell. FIG. 3 is a schematic diagram for explaining a method of manufacturing the solar cell 3 according to the first embodiment of the present disclosure. In the manufacturing method shown in FIG. 3, first, a silicon wafer is cleaned (FIG. 3(a)). The cleaning may be any cleaning which is publicly known. Although the process will not be described in detail as the process is publicly known, in the cleaning process, first, rough cleaning is performed, then finish cleaning is performed, and finally, etching is performed. In the rough cleaning, for example, a wafer in a state of being adhered to a base is cleaned with a neutral cleaning agent, to efficiently remove stains in the gap of the silicon wafer. Next, in the finish cleaning, the silicon wafer detached from the base is cleaned using an alkaline cleaning agent. In the finish cleaning, a surface of the silicon wafer is chemically polished by a synergetic effect of an alkaline component included in the alkaline cleaning agent and a surfactant, to facilitate formation of a texture structure in the next process. In the final process, etching, the silicon wafer is immersed in sodium hydroxide or potassium hydroxide, to etch the surface of the silicon wafer and form recesses and protrusions (texture structure) of a pyramid shape on the surface of the silicon wafer. The texture structure may be a random texture in which a large number of the recesses and protrusions of the pyramid shape are irregularly placed and the heights (sizes) thereof are uneven. The recesses and protrusions of the pyramid shape have, for example, a width of a few µm to a few tens of µm, and a height of a few µm to a few tens of µm. A vertex and a valley of each pyramid shape may be round. In order to form a uniform texture structure over the surface of the silicon wafer, an additive for controlling the etching may be used. As such an additive, isopropyl alcohol or the like may be employed.

Next, a film is formed over the surface of the silicon wafer (FIG. 3(b)). The film formation is performed using, for example, a CVD (Chemical Vapor Deposition) apparatus. The film formation process will now be described exemplifying a case in which the silicon wafer is an n-type crystalline silicon substrate (hereinafter simply referred to as a "silicon substrate"). In this case, in the film formation process, for example, over a first primary surface of the silicon substrate, a first i-type amorphous silicon layer (first intrinsic amorphous silicon layer), a first amorphous silicon layer of a p-type, and a first transparent conductive layer are layered in this order. In addition, over a second primary surface of the silicon substrate, a second i-type amorphous silicon layer (second intrinsic amorphous silicon layer), a second amorphous silicon layer of an n-type, and a second transparent conductive layer are layered in this order.

The silicon substrate is formed by adding conductivity on a monocrystalline silicon substrate. The silicon substrate is formed, for example, by containing phosphorus atoms, which introduce electrons to Si atoms (silicon atoms), as impurities in the monocrystalline silicon substrate. The silicon substrate may alternatively be an n-type monocrystalline silicon substrate, and may have, for example, a thickness of 50-300 µm, a specific resistance of 0.5-30 Ω·cm, and an n-type impurity concentration of 1×10¹⁴-3×10¹⁶cm⁻³, or may have a thickness of 100-200 µm and a specific resistance of 1-10 Ω·cm. The n-type monocrystalline silicon substrate may have an n-type high-concentration impurity layer having a thickness of about 50-500 nm on the front surface and the back surface.

The first and second i-type amorphous silicon layers are desirably formed from i-type hydrogenated amorphous silicon including silicon and hydrogen. Each of the first and second i-type amorphous silicon layers has a thickness of, for example, about 3-20 nm. Alternatively, the first and second i-type amorphous silicon layers may be omitted. The first amorphous silicon layer is desirably formed from p-type hydrogenated amorphous silicon including silicon, hydrogen, and boron, and the second amorphous silicon layer is desirably formed from n-type hydrogenated amorphous silicon including silicon, hydrogen, and phosphorus.

The first and second transparent conductive layers desirably have a conductive oxide as a primary constituent. As the conductive oxide, for example, indium oxide, tin oxide, or zinc oxide or the like may be used as a single entity or as a mixture. As the conductive oxide, an indium-based oxide including indium oxide as the primary constituent is desirable from the viewpoints of conductivity, optical characteristics, and long-term reliability, and, for example, indium oxide doped with tungsten (IWO), indium tin oxide doped with tin (ITO), or the like, may be used. Each of the first and second transparent conductive layers may be a single layer, or may have a layered structure formed from a plurality of layers.

The first and second transparent conductive layers have a lower resistance and a higher conductivity than the first and second i-type amorphous silicon layers, and the first amorphous silicon layer and the second amorphous silicon layer, respectively. For example, each of the first and second transparent conductive layers may have a specific resistance of 1×10⁻⁴-1×10⁻³ Ω·cm, and a thickness of 50-200 nm. As film formation conditions when these layers are formed, for example, conditions described in JP 2021-144960 A may be employed.

Then, a printing process is performed (FIG. 3(c)). In the printing process, for example, a silver paste is screen-printed over the first transparent conductive layer in the shape of a comb-type electrode, and, after provisional drying, a silver paste is screen-printed over the second transparent conductive layer in the shape of a comb-type electrode. Then, by heating the structure at a temperature of about 180°C for a period of longer than or equal to a few tens of minutes, main drying is carried out. In this manner, a first-primary-surface-side collector electrode is formed over the first transparent conductive layer and a second-primary-surface-side collector electrode is formed over the second transparent conductive layer. As the silver paste, a silver paste in which minute particles of silver are dispersed in an insulating resin may be used. In the case of a diffusion-based solar cell, a fire-through process is necessary, and thus the drying is performed at a higher temperature such as about 800°C.

A case has been described in which the silver paste is applied by the method of screen printing to form the first and second primary-surface-side collector electrodes. Alternatively, the first and second primary-surface-side collector electrodes may be formed through other methods such as an inkjet method, a conductive line adhesion method, a spray method, a vacuum evaporation method, a sputtering method, a plating method, or the like. From the viewpoint of productivity, the screen printing method using the silver paste, and plating method using copper, are desirable. In addition, other materials such as aluminum may be used as the materials of the first and second primary-surface-side collector electrodes. Each of the first and second primary-surface-side collector electrodes includes a plurality of bus bar electrodes placed with a spacing in the Y direction and extending in the X direction, and a plurality of finger electrodes placed with a spacing in the X direction and extending in the Y direction. The wiring member 4 is placed on the bus bar electrode, and contacts the bus bar electrode. Furthermore, the finger electrode is orthogonal to the bus bar electrode, and contacts the bus bar electrode.

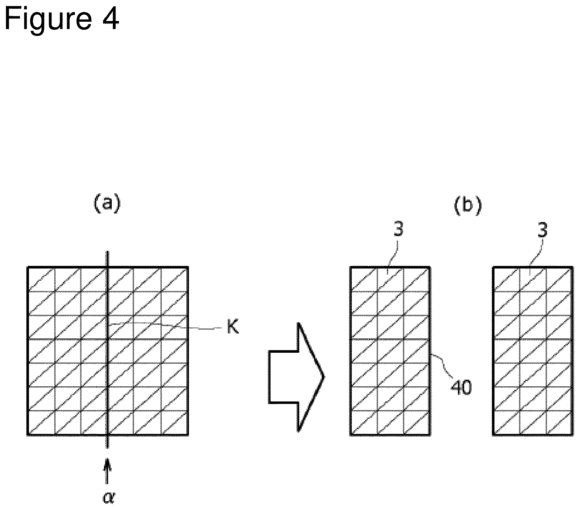

Finally, a fracturing process is performed (FIG. 3(d)). The fracturing is performed by scanning (moving) laser light of a continuous wave over a fracture location K, and sprinkling pure water from a spraying device to a laser irradiated location within 0.2 seconds after the irradiation of the laser light, desirably, within 0.1 seconds after the irradiation of the laser light, to cool the corresponding location. In this manner, a rapid temperature change is caused in a very short period of time at the location irradiated with the laser. The fracturing is performed based on this rapid temperature difference, and, as shown in FIGs. 4(a) and 4(b), the solar cell is divided into a plurality of solar cells with the fracture location K as a boundary. An arrow a shown in FIG. 4(a) shows a scanning direction of the laser light.

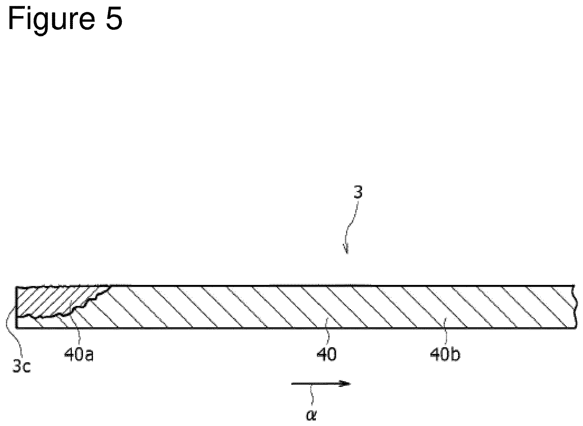

FIG. 5 is a plan view of a cross section (fractured surface) 40 of the solar cell 3 shown in FIG. 4(b), viewed from the side. In FIG. 5, the arrow a shows the scanning direction of the laser light. In the first embodiment of the present disclosure, cooling water is sprinkled from the spray device to the laser irradiated location within 0.2 seconds (desirably, within 0.1 seconds) after the irradiation of the laser light, to cause a rapid temperature change at the laser irradiated location, and the solar cell 3 is fractured. In this fracturing, as shown in FIG. 5, a first cross section part 40a, which is rough, which includes a laser irradiation trace, and which has a texture structure having a root mean square roughness of 10 µm to a few tens of µm, is caused only in a range within a few mm in the scanning direction from an end surface 3c on a side where laser light irradiation in the solar cell 3 starts, and a second cross section part 40b in the laser light scanning direction other than the first cross section part 40a is a fine surface with high flatness with only recesses and protrusions having a root mean square roughness of within a few µm. In this fracturing method, a part of the first cross section part 40a may sometimes protrude in the thickness direction from a light receiving surface or a back surface of the solar cell in which the part of the first cross section part 40a is exposed, and the first cross section part 40a may include a protrusion which protrudes in the thickness direction from the light receiving surface or the back surface of the solar cell in which the first cross section part 40a is exposed. For example, with reference to FIG. 5, when a surface on an upper side of the page in the solar cell 3 is a light receiving surface 80 and a surface on a lower side of the page in the solar cell 3 is a back surface 81, the light receiving surface 80 may include a protrusion which protrudes in the thickness direction. The protrusion is a laser irradiated surface, and the protruding surface changes depending on whether the laser irradiated surface is the light receiving surface or the back surface. Thus, it is not possible that both of the light receiving surface and the back surface have the protrusion. In addition, because the first cross section part 40a and the second cross section part 40b do not include a cross section along a cleavage direction, a strength of the solar cell may be improved in comparison to the case in which a cross section part includes a cross section along the cleavage direction.

A cross section 40 includes the first cross section part 40a having a root mean square roughness of greater than or equal to a first value, and a second cross section part 40b having a root mean square roughness of less than the first value. The first cross section part 40a exists only within a range of a few mm in the scanning direction from the end surface 3c on the side of the start of the laser light irradiation on the solar cell 3. In other words, the cross section 40 includes the first cross section part 40a having the laser irradiation trace at least at a part thereof, and the second cross section part 40b having no laser irradiation trace, and the first cross section part 40a exists only within the range of a few mm in the scanning direction from the end surface 3c on the side where the laser light irradiation on the solar cell 3 starts.

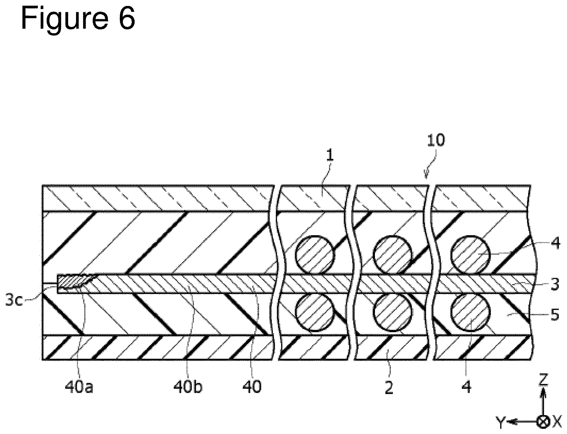

Therefore, as shown in FIG. 6, the wiring member 4 is placed to be closer to the second cross section part 40b than to the first cross section part 40a at a position intersecting the cross section 40 in the plan view viewed from the light receiving surface side in the thickness direction. In addition, by placing the wiring member 4 at a position distanced by about 1 cm from the end surface 3c on the side of the start of the laser light irradiation, it becomes possible to prevent contact of the wiring member 4 with the first cross section part 40a having a large root mean square roughness, and to cause the wiring member 4 to contact only the second cross section part 40b having a small root mean square roughness.

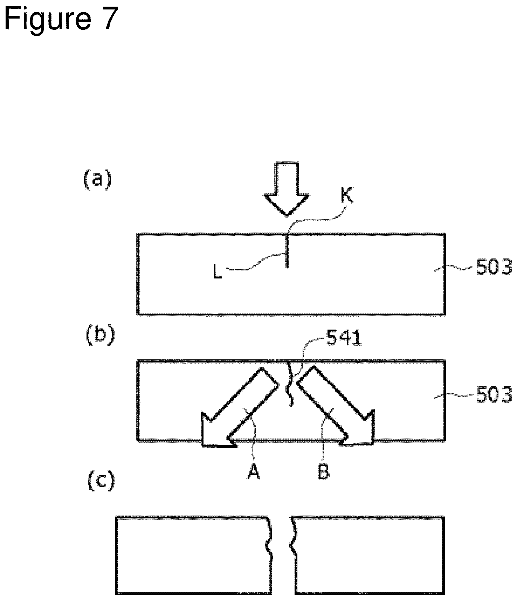

FIG. 7 is a schematic diagram for explaining a fracturing method of a solar cell in the related art. With reference to FIG. 7, in the fracturing method of the related art, as shown in FIG. 7(a), laser light is scanned along the fracture location K (the scanning direction is a direction perpendicular to the page of FIG. 7), to form a groove 541 (refer to FIG. 7(b)) to a depth L of about a half the thickness of the solar cell over an entire region of the fracture location K of a solar cell 503 before fracturing. Then, as shown in FIG. 7(b), mechanical forces in opposite directions from each other, as shown by arrows A and B, are applied to the solar cell 503 in which about half of the cell in the thickness direction is separated, to cleave the remaining thickness portion with the groove 541 as a starting point, to thereby realize the fracturing of the solar cell 503 as shown in FIG. 7(c).

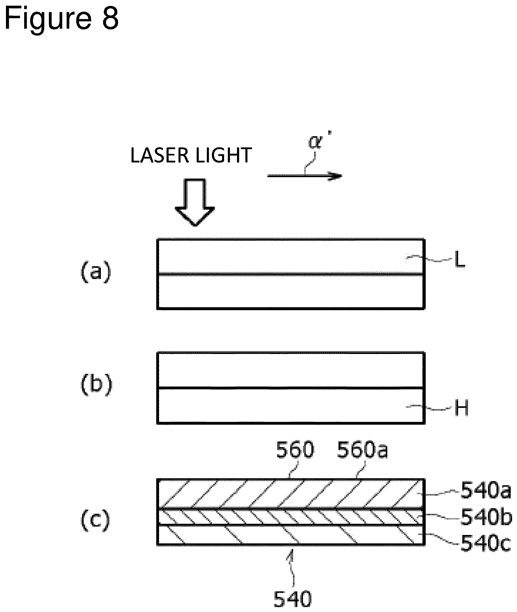

FIG. 8 is a schematic diagram for explaining a structure of a fractured surface 540 caused by a fracturing method of the solar cell of the related art. In FIG. 8, an arrow α' shows a scanning direction of laser light. As shown in FIG. 8(a), in the fracturing method of the related art, first, the groove of the depth L is formed by the laser light over the entire region in the scanning direction. Then, as shown in FIG. 8(b), a mechanical force is applied to a remaining depth portion H to separate the structure through cleaving, and to divide the solar cell. In this case, as shown in FIG. 8(c), the fractured surface 540 includes three sections of different structures, that is, a laser trace-containing section 540a, a cleavage trace-existing section 540b, and a flat section 540c.

The laser trace-containing section 540a includes a portion in which silicon is fused by the irradiation of the laser light and is then solidified, has a large root mean square roughness of 10 µm to a few tens of µm, and has a shape unrelated to the cleavage direction. The laser trace-containing section 540a also has a portion protruding from a surface of the silicon substrate. The cleavage trace-existing section 540b has a portion along the cleavage direction of the silicon (slanted with respect to the cross section) due to the application of the mechanical stress, and has a rough step at a boundary with the laser trace-containing section 540a. A root mean square roughness of the cleavage trace-existing section 540b is greater than or equal to 10 µm. The flat section 540c does not have a protruding portion in the thickness direction, and a root mean square roughness of the flat section 540c is smaller than the root mean square roughness of the laser trace-containing section 540a and smaller than the root mean square roughness of the cleavage trace-existing section 540b.

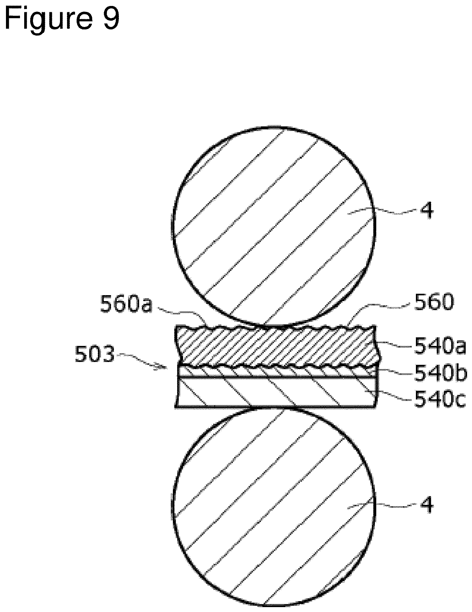

In the fracturing method of the related art, the laser trace-containing section 540a having a large root mean square roughness is inevitably caused over the entire region in the scanning direction of the laser light, at an edge 560a of a surface 560 on one side in the thickness direction of the fractured surface 540 of the solar cell 503 which is manufactured. Therefore, as shown in FIG. 9, the wiring member 4 inevitably contacts the laser trace-containing section 540a having recesses and protrusions with a large root mean square roughness of 10 µm to a few tens of µm. Therefore, when the solar cell module having such a solar cell 503 experiences an excessive external force due to snowfall, typhoon, or the like, the edge 560a experiences an excessive force from the wiring member 4, and there is a possibility of a crack being generated in the solar cell 3 with the edge 560a as the starting point.

On the contrary, in the solar cell module 10 of the present disclosure, as shown in FIG. 6, the wiring member 4 only contacts the second cross section part 40b, which is even and smooth, in the solar cell 3, and does not contact the first cross section part 40a having a large root mean square roughness of 10 µm to a few tens of µm. Therefore, even when the solar cell module 10 experiences an excessive external force due to snowfall, typhoon, or the like, the crack does not tend to be easily generated in the solar cell 3. Thus, even though the solar cell module 10 is manufactured using the solar cell 3 with fracturing, the solar cell module 10 having a superior load resistance, and in which the solar cell 3 tends to be not easily cracked, can be realized.

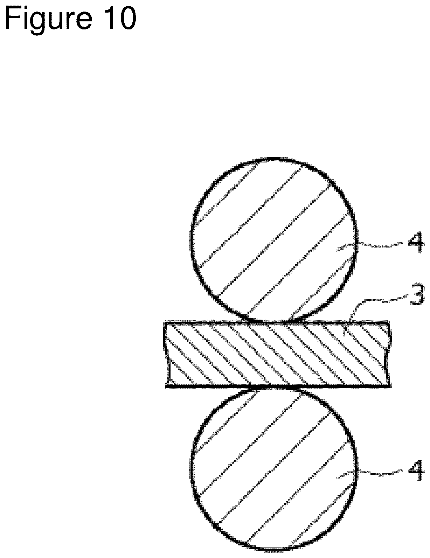

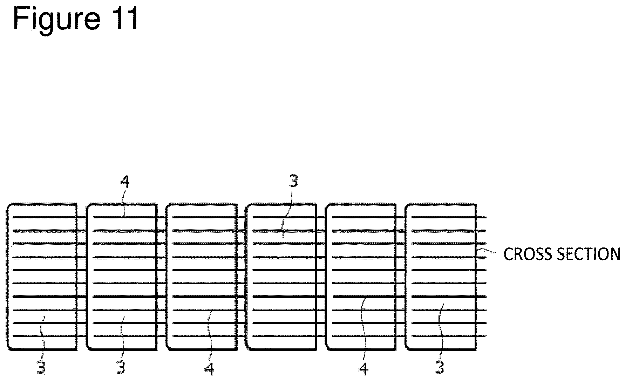

The solar cell 3 may have an approximately rectangular shape with a long side and a short side shorter than the long side in the plan view viewed from the light receiving surface side in the thickness direction, and the cross section 40 may be provided along the long side. In addition, as shown in FIG. 10, the wiring member 4 may have an approximately circular cross section with a diameter of greater than or equal to 250 µm, and, as shown in FIG. 11, at least six wiring members 4 may be connected to the light receiving surface of the solar cell 3.

As the wiring member of the solar cell module, a wiring member having a flat, parallelepiped shape may be used, or a wiring of an approximately circular cross section may be used. In view of this, when the wire of the approximately circular cross section is used as the wiring member 4 as shown in FIG. 10, the wiring member 4 contacts the solar cell 3 through a contact close to a line contact, and, in comparison to the case in which the wiring member of the parallelepiped shape is used as the wiring member, a contact area of the wiring member 4 with respect to the solar cell 3 can be significantly reduced, and a contact surface pressure applied from the wiring member 4 to the solar cell 3 can be significantly increased. Therefore, when such a condition is satisfied, the suppression of the cracks of the solar cell 3, which is an advantageous effect of the present disclosure, can be more significant. When the wiring member has a flat, parallelepiped shape, for example, the wiring members in the number of greater than or equal to 6 and less than or equal to 8 are desirably connected to the solar cell. In addition, when the wiring member is the wire, for example, the wiring members in the number of greater than or equal to 9 and less than or equal to 20 are desirably connected to the solar cell.

With reference to FIG. 10, the thickness of the solar cell 3 may be less than or equal to 150 µm. For cost reduction and passivation improvement, the thickness of the silicon wafer is reduced from year to year. However, when the thickness of the silicon wafer is reduced, the rigidity of the solar cell 3 is reduced, resulting in reduction of the load resistance of the solar cell 3. In particular, when the thickness of the solar cell 3 is less than or equal to 150 µm, in consideration of the fact that wires of a diameter of greater than or equal to 250 µm exist and that many wires have a diameter of greater than or equal to 300 µm, in some cases, the thickness of the solar cell 3 becomes about a half of the diameter of the wire, in which case, the cracks of the solar cell 3 tend to particularly easily occur. Therefore, in these cases, the suppression of the cracks of the solar cell 3, which is an advantageous effect of the present disclosure, can be more significant.

The light-receiving-surface-side protection member may be the front surface glass 1, and the back-surface-side protection member may be the resin sheet 2. The glass, the wiring member 4, and the solar cell 3 are hard. Therefore, when the thickness of the sealing member 5 is thin, and the solar cell module 10 is bent, it is difficult to absorb the stress with the sealing member 5, and the solar cell 3 tends to easily experience an excessive load. Therefore, in these cases, the suppression of the cracks of the solar cell 3, which is an advantageous effect of the present disclosure, may be more significant. Furthermore, when the back-surface-side protection member is the resin sheet 2, in comparison to the case in which the back-surface-side protection member is the glass, the solar cell 3 tends to more easily deflect. Therefore, when the back-surface-side protection member is the resin sheet 2, the suppression of the cracks of the solar cell 3, which is an advantageous effect of the present disclosure, can be more significant.

In addition, when the root mean square roughness of the second cross section part 40b is less than or equal to 1/3 of the root mean square roughness (RMS) of the first cross section 40a, and the surface roughnesses of the two cross section parts 40a and 40b differ significantly from each other, the suppression of the cracks of the solar cell 3, which is an advantageous effect of the present disclosure, can be more significant. In addition, when a cross-sectional area of the second cross section part 40b is greater than or equal to 9 times a cross-sectional area of the first cross section part 40a, even when the number of the wiring members 4 is large, it is possible to suppress contact of the wiring member 4 with the first cross section part 40a. When the cross-sectional area of the second cross section part 40b is greater than or equal to 20 times the cross-sectional area of the first cross section part 40a, even when the number of the wiring members 4 is large, it is possible to further effectively suppress the contact of the wiring member 4 with the first cross section part 40a. In addition, when the cross-sectional area of the second cross section part 40b is greater than or equal to 40 times the cross-sectional area of the first cross section part 40a, even when the number of the wiring member 4 is about 20, it is possible to effectively suppress contact of the wiring member 4 with the first cross section part 40a.

Moreover, the solar cell 3 may have a pn junction formed in a surface shape on one of the light receiving surface side in the thickness direction and the back surface side in the thickness direction. The first cross section part 40a may be positioned with a spacing in the thickness direction from the pn junction. Such a solar cell module 10 may be manufactured by irradiating the laser light to the solar cell 3 from a side opposite to the pn junction side in the thickness direction, in the fracturing method explained above with reference to FIGs. 3(d), 4, and 5, in which the laser irradiated location is cooled while the laser light is irradiated.

As an example, in the case of the heterojunction solar cell, the pn junction is formed on the back surface side in the thickness direction with a center of the solar cell in the thickness direction as a reference, using an n-type silicon substrate. Therefore, in this case, the laser light is irradiated from the light receiving surface side in the thickness direction. On the other hand, in the case of the PERC solar cell, the pn junction is formed on the front surface side (light receiving surface side) in the thickness direction with the center of the solar cell in the thickness direction as a reference, using a p-type silicon substrate. Therefore, in this case, the laser light is irradiated from the back surface side in the thickness direction. According to the present solar cell module 10, the laser light does not reach the pn junction of the solar cell 3, which significantly affects the cell conversion efficiency, and therefore, reduction of the cell conversion efficiency can be suppressed.

The solar cell 3 may have a pn junction formed in a surface shape on one of the light receiving surface side in the thickness direction and the back surface side in the thickness direction. The first cross section part 40a may include a portion overlapping the pn junction. An average value of a sheet resistance on the pn junction side in a lateral direction of a portion including the first cross section part 40a may be larger than an average value of a sheet resistance on the pn junction side in the lateral direction of a portion including the second cross section part 40b.

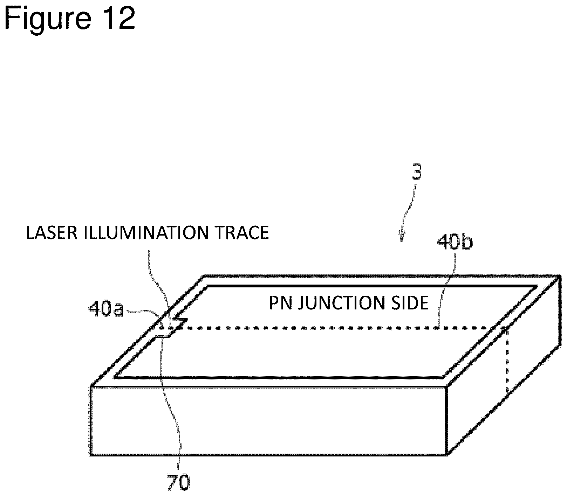

With the present configuration, the laser light can be irradiated from the pn junction side in the thickness direction, and therefore, a degree of freedom of an irradiation direction of the laser light can be increased. Furthermore, because the laser light can be irradiated from the light receiving surface side in the thickness direction even for the PERC solar cell, the PERC solar cell can be easily manufactured. Moreover, when a region of a high sheet resistance is formed at a portion of an edge of the solar cell 3, it becomes easier to suppress reduction of output power of the solar cell 3. As shown in FIG. 12, in the solar cell 3 of the present configuration, a high-sheet-resistance region 70 having a high sheet resistance exists at an end in the scanning direction of the laser light including the first cross section part 40a including the laser irradiation trace, and the high-sheet-resistance region 70 reaches a cell end of the solar cell 3. Such a solar cell 3 can be easily manufactured, in the case of the heterojunction solar cell, by not forming a transparent conductive layer at the end in the scanning direction of the laser light including the first cross section pat 40a. As a method of manufacturing such a solar cell 3, various methods may be employed, such as a method in which a mask is formed at the end in the scanning direction of the laser light and the transparent conductive layer is partially not formed in this region, and a method in which, after the transparent conductive layer is formed over an entire region of one end surface in the thickness direction of the solar cell, the transparent conductive film existing at the end in the scanning direction of the laser light is removed using a chemical agent. In the case of the PERC solar cell, such a solar cell 3 can be manufactured by mask diffusion at the high-sheet-resistance region 70, or removal by a chemical agent of an emitter (pn junction) at the high-sheet-resistance region 70.

### (Second Embodiment)

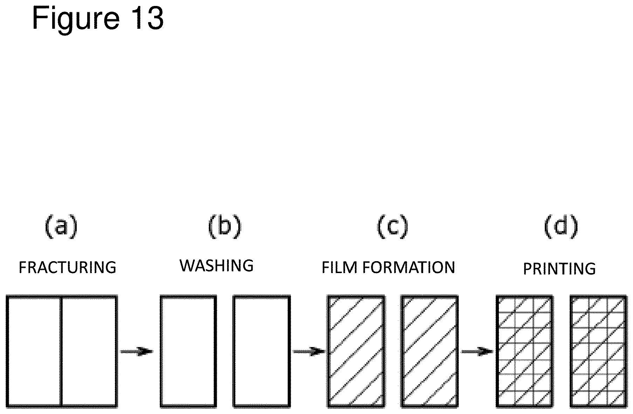

FIG. 13 is a schematic diagram corresponding to FIG. 3, for explaining a method of manufacturing a solar cell according to a second embodiment of the present disclosure. In the manufacturing method, first, a silicon wafer is divided (FIG. 13(a)). As the method of fracturing, the fracturing method in which the laser irradiated location is cooled while the laser light is irradiated, described above with reference to FIGs. 3(d), 4, and 5, is employed. Then, each of the divided silicon wafers is cleaned (FIG. 13(b)), film formation is performed on the cleaned silicon wafer (FIG. 13(c)), and finally, an collector electrode is formed through printing on the film-formed silicon wafer (FIG. 13(d)). The cleaning in FIG. 13(b) may be performed similarly to the cleaning described above with reference to FIG. 3(a), and the film formation of FIG. 13(c) may be performed similarly to the film formation described above with reference to FIG. 3(b). The printing of FIG. 13(d) may be performed similarly to the printing described above with reference to FIG. 3(c). The present inventors have confirmed that, even when the method of FIG. 13 is employed, the first cross section part which has a large root mean square roughness and in at least a part of which a laser irradiation trace is present, and a second cross section part which has a smaller root mean square roughness than the first cross section part and in which no laser irradiation trace is present, are caused in the cross section (cell fractured surface).

When this method is employed, the texture structure (recesses and projections for preventing reflection) can be formed by the cleaning of FIG. 13(b) on the cell fractured surface of each silicon wafer generated by the fracturing of FIG. 13(a), resulting in improvement of the cell conversion efficiency. In addition, because a thin film, for example, a thin film having a thickness of greater than or equal to 5 nm, can be formed over the cell fractured surface in the film formation of FIG. 13(c), the fractured surface can be passivated with the thin film.

It is difficult for a large-size silicon wafer such as G12 to apply processes of cleaning, film formation, and printing. Therefore, when such a large-size silicon wafer is used, desirably, the solar cell is fabricated by the method according to the second embodiment of the present disclosure in which the fracturing is first performed. In the solar cell fabricated by the method shown in FIG. 13, in order to prevent short-circuiting, it is necessary to form one or more regions of high sheet resistance between the cross section and the electricity collecting area on the pn junction side.

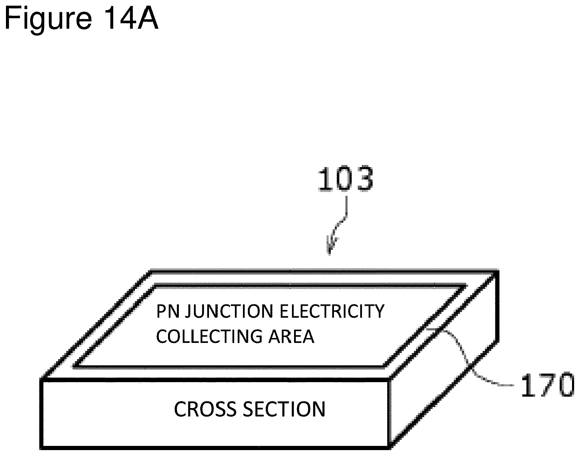

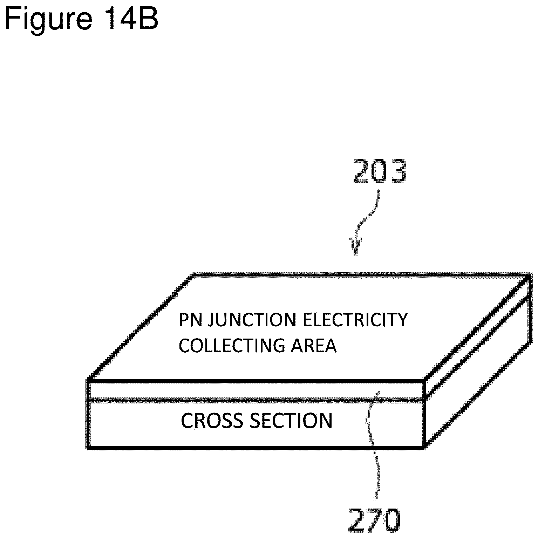

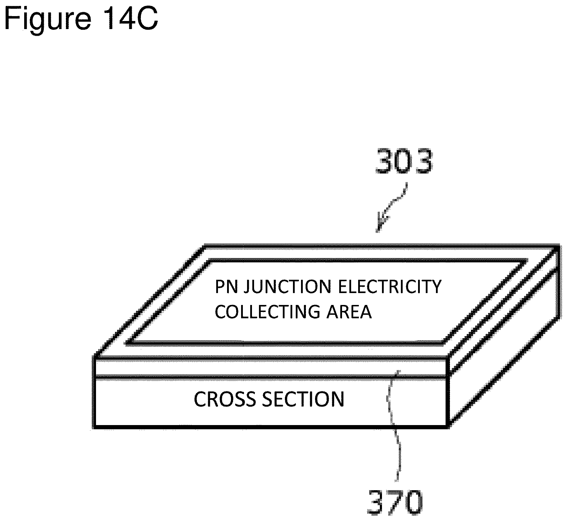

For example, a solar cell 103, a perspective diagram of which is shown in FIG. 14A, has a high-sheet-resistance region 170 having a high sheet resistance, at an edge of the back surface. A solar cell 203, a perspective diagram of which is shown in FIG. 14B, has a high-sheet-resistance region 270 having a high sheet resistance, at a part of the cross section (side surface), and a solar cell 303, a perspective diagram of which is shown in FIG, 14C, has a high-sheet-resistance region 370 having a high sheet resistance, at a region overlapping the edge of the back surface in the thickness direction and at a part of the cross section (side surface). The region of high sheet resistance may be fabricated, in the case of the heterojunction solar cell, by not forming the transparent conductive film. More specifically, in the case of the heterojunction solar cell, in the example configuration shown in FIG. 14A, there is no transparent conductive film over an entire outermost circumference on the end surface in the thickness direction on the pn junction side. In addition, in the case of the heterojunction solar cell, in the example configuration shown in FIG. 14B, there is no transparent conductive film over the entire circumference on the pn junction side of the side surface of the solar cell. In the case of the heterojunction solar cell, in the example configuration shown in FIG. 14C, there is no transparent conductive film over the entire outermost circumference on the end surface in the thickness direction on the pn junction side and over the entire circumference on the pn junction side of the side surface of the solar cell. In the case of the PERC solar cell or the TOPCON solar cell, the region of high sheet resistance can be fabricated through mask diffusion, etch back (removal of emitter by a chemical agent), isolation by laser, or the like.,

### (Third Embodiment)

In the first and second embodiments of the present disclosure, fracturing has been described in which the laser irradiated location is cooled while the laser light is irradiated. Furthermore, a case has been described in which the first cross section part 40a having a large root mean square roughness is formed on an end on the side of the start of scanning of the laser light in the laser scanning direction on the end surface on one side in the thickness direction of the solar cell. Alternatively, a configuration may be employed in which there are only the second cross section parts having no laser trace and having a small root mean square roughness on both end surfaces on both sides in the thickness direction of the solar cell.

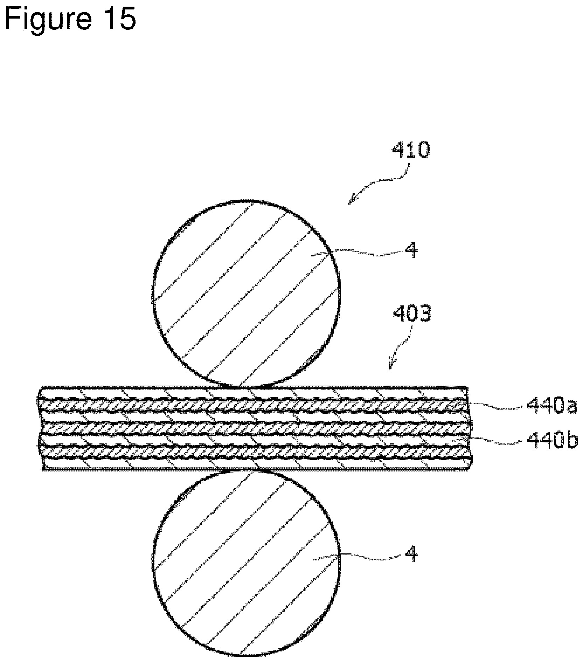

Specifically, a silicon wafer may be fractured using a stealth laser. For example, the silicon wafer may be fractured by focusing a pulse laser inside the silicon wafer, to thereby generate a controlled crevice. More specifically, as shown in FIG. 15, a first cross section part 440a of a band shape having a large root mean square roughness and including a laser trace is fabricated inside the silicon wafer by scanning a pulse laser in a state in which the pulse laser is focused at a predetermined depth inside the silicon wafer. In this process, the first cross section parts 440a of the band shape are formed inside the silicon wafer in the number based on the thickness of the silicon wafer or the like. Two first cross section parts of the band shape which differ from each other may be formed by first scanning the laser light in a state in which the laser light is focused at a first depth, and then scanning the laser light in a state in which the laser light is focused at a second depth that is different from the first depth. A plurality of first cross section parts 440a of the band shape can be formed by repeating this process a plurality of times.

The fracturing is performed by applying a mechanical force (mechanical stress) after the plurality of the first cross section parts 44a of the band shape are formed. In a solar cell 403 fabricated through this method, the first cross section part 440a having a large root means square roughness, and including a laser irradiation trace, only exists in the middle of the cross section, and does not exist on either of the light receiving surface or the back surface. End surfaces on both sides in the thickness direction (light receiving surface and cell end surface) of the solar cell 403 are included in a second cross section part 440b in which there is no laser trace and which has a small root mean square roughness. A focal point of the stealth laser (focus depth of the pulse laser) is set at a depth where there is no pn junction. In this manner, influence of the laser light to the pn junction, which significantly affects the cell conversion efficiency, is a prevented. Because it is difficult to use the stealth laser when there is the texture structure, desirably, the solar cell 403 used in a solar cell module 410 according to the third embodiment of the present disclosure is fabricated by first fracturing, then cleaning, then forming a film, and finally printing. Alternatively, the stealth laser may be used in a solar cell having a one-surface texture structure (a structure in which the texture is formed only on the light receiving surface).

While the foregoing has described what are considered to be the best mode and/or other examples, it is understood that various modifications may be made therein, and that the subject matter disclosed herein may be implemented in various forms and examples, and that they may be applied in numerous applications, only some of which have been described herein. It is intended by the following claims to claim any and all modifications and variations that fall within the true scope of the present teachings.

## Claims

1. A solar cell module (10, 410) comprising:
a solar cell string (50) in which a plurality of solar cells (3, 103, 203, 303, 403) are electrically connected in series by a wiring member (4);
a light-receiving-surface-side protection member (1) placed on a light receiving surface side in a thickness direction of the solar cell string (50);
a back-surface-side protection member (2) placed on a back surface side in the thickness direction of the solar cell string (50); and
a sealing member (5) provided between the light-receiving-surface-side protection member (1) and the back-surface-side protection member (2), that covers the solar cell string (50), wherein
the solar cell (3, 103, 203, 303, 403) has a light receiving surface (80), a back surface (81), and a cross section (40) positioned between the light receiving surface (80) and the back surface (81),
the cross section (40) includes a first cross section part (40a) having a root mean square roughness of greater than or equal to a first value, and a second cross section part (40b) having a root mean square roughness of less than the first value, and
the wiring member (4) is placed to be closer to the second cross section part (40b) than to the first cross section part (40a), at a position intersecting the cross section (40) in plan view viewed from the light receiving surface side in the thickness direction.

2. A solar cell module (10, 410) comprising:
a solar cell string (50) in which a plurality of solar cells (3, 103, 203, 303, 403) are electrically connected in series by a wiring member (4);
a light-receiving-surface-side protection member (1) placed on a light receiving surface side in a thickness direction of the solar cell string (50);
a back-surface-side protection member (2) placed on a back surface side in the thickness direction of the solar cell string (50); and
a sealing member (5) provided between the light-receiving-surface-side protection member (1) and the back-surface-side protection member (2), that covers the solar cell string (50), wherein
the solar cell (3, 103, 203, 303, 403) has a light receiving surface (80), a back surface (81), and a cross section (40) positioned between the light receiving surface (80) and the back surface (81),
the cross section (40) includes a first cross section part (40a) having a laser irradiation trace in at least a part thereof, and a second cross section part (40b) in which there is no laser irradiation trace, and
the wiring member (4) is placed to be closer to the second cross section part (40b) than to the fist cross section part (40a), at a position intersecting the cross section (40) in plan view viewed from the light receiving surface side in the thickness direction.

3. The solar cell module (10) according to claim 2, wherein
a texture structure for preventing reflection are provided on the cross section.

4. The solar cell module (10) according to claim 1 or 2, wherein
at least a part of the first cross section part (40a) protrudes in the thickness direction from the light receiving surface (80) or the back surface (81) of the solar cell (3).

5. The solar cell module (10) according to claim 1 or 2, wherein
the first cross-section part (40a) and the second cross-section part (40b) include no cross section along a cleavage direction.

6. The solar cell module (10) according to claim 1 or 2, wherein
the solar cell (3) has an approximately rectangular shape with a long side and a short side shorter than the long side in plan view viewed from the light receiving surface side in the thickness direction, and
the cross section (40) is provided along the long side.

7. The solar cell module (10) according to claim 1 or 2, wherein
the wiring member (4) has an approximately circular cross section with a diameter of greater than or equal to 250 µm, and
six or more wiring members (4) are connected to a light receiving surface of the solar cell (3).

8. The solar cell module (10) according to claim 1 or 2, wherein
a thickness of the solar cell (3) is less than or equal to 150 µm.

9. The solar cell module (10) according to claim 1 or 2, wherein
the light-receiving-surface-side protection member (1) is formed from glass.

10. The solar cell module (10) according to claim 1 or 2, wherein
the back-surface-side protection member (2) is formed from a resin sheet.

11. The solar cell module (10) according to claim 1 or 2, wherein
the root mean square roughness of the second cross section part (40b) is less than or equal to 1/3 of the root mean square roughness of the fist cross section part (40a).

12. The solar cell module (10) according to claim 1 or 2, wherein
a cross-sectional area of the second cross section part (40b) is greater than or equal to 9 times a cross-sectional area of the first cross section part (40a).

13. The solar cell module (10) according to claim 1 or 2, wherein
the solar cell (3) has a pn junction formed in a surface shape on one of the light receiving surface side in the thickness direction and the back surface side in the thickness direction, and
the first cross section part (40a) is positioned with a spacing in the thickness direction from the pn junction.

14. The solar cell module (10) according to claim 1 or 2, wherein
the solar cell (3) has a pn junction formed in a surface shape on one of the light receiving surface side in the thickness direction and the back surface side in the thickness direction,
the first cross section part (40a) has a portion overlapping the pn junction, and
an average value of a sheet resistance on the pn junction side in a lateral direction of a surface of a portion including the first cross section part (40a) is greater than an average value of a sheet resistance on the pn junction side in a lateral direction of a surface of a portion including the second cross section part (40b).

15. The solar cell module (410) according to claim 1 or 2, wherein
the solar cell (403) has a pn junction formed in a surface shape on one of the light receiving surface side in the thickness direction and the back surface side in the thickness direction, and
the first cross section part (440a) exists at a position spaced in the thickness direction from the light receiving surface of the solar cell (403), the back surface of the solar cell (403), and the pn junction.

16. The solar cell module (10) according to claim 3, wherein
the cross section (40) is covered with a thin film of a thickness of greater than or equal to 5 nm, and
one or more regions of high sheet resistance (170, 270, 370) exist between the cross section (40) and an electricity collecting area on a pn junction side.
